(19) Europäisches Patentamt
European Patent Office
Office européen des brevets

(11) **EP 4 317 496 A1**

(12) **EUROPEAN PATENT APPLICATION**
published in accordance with Art. 153(4) EPC

(43) Date of publication:
**07.02.2024 Bulletin 2024/06**

(21) Application number: 22780485.3

(22) Date of filing: **24.03.2022**

(51) International Patent Classification (IPC):
**C22C 13/02** (2006.01)     **C22C 30/04** (2006.01)
**B23K 35/22** (2006.01)     **B23K 35/26** (2006.01)
**H05K 3/34** (2006.01)

(52) Cooperative Patent Classification (CPC):
**B23K 35/22; B23K 35/26; C22C 13/02; C22C 30/04; H05K 3/34**

(86) International application number:
**PCT/JP2022/014030**

(87) International publication number:
**WO 2022/210271 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.03.2021   JP 2021058897**
**23.03.2022   JP 2022046663**

(71) Applicant: **Tamura Corporation**
**Tokyo 178-8511 (JP)**

(72) Inventors:
• **NAKANO, Takeshi**
  **Iruma-shi Saitama 358-0032 (JP)**
• **SAKAMOTO, Isao**
  **Iruma-shi Saitama 358-0032 (JP)**
• **NARUSE, Shouichirou**
  **Iruma-shi Saitama 358-0032 (JP)**
• **SHIMADA, Toshiaki**
  **Iruma-shi Saitama 358-0032 (JP)**
• **OKUBO, Koichi**
  **Iruma-shi Saitama 358-0032 (JP)**

(74) Representative: **Cabinet Beau de Loménie**
**158, rue de l'Université**
**75340 Paris Cedex 07 (FR)**

(54) **SOLDER ALLOY**

(57) Providing a solder alloy comprising: 0.1 mass% or more and 3 mass% or less of Ag; 8 mass% or more and 15 mass% or less of Cu; 30 mass% or more and 40 mass% or less of Sb; and the balance being Sn, capable of suppressing remelting of a solder joint to be formed even in a high temperature environment.

FIG. 1

EP 4 317 496 A1

**Description**

Technical Field

The present invention relates to a solder alloy.

Background Art

As a bonding material for bonding an electronic component or a semiconductor device (an electronic component using a semiconductor element) onto an electronic circuit formed on a substrate, a solder alloy is mainly used.

Here, characteristics required for electronic components and semiconductor devices are increasing year by year, and accordingly, electronic products using power semiconductor devices (i.e. semiconductor devices on which power semiconductor elements are mounted; hereinafter referred to as "power devices") capable of handling high voltages and large currents are also increasing.

As described above, power devices can handle high voltages and large currents and can withstand high operating temperatures. For this reason, in solder bonding between a power device and a substrate (for example, a heat dissipation substrate, a Cu substrate, or the like), it is required that the formed solder joint be hardly remelted at the operating temperature.

Also in the power device, a power semiconductor element (for example, a Si element, a SiC element, a GaN element, or the like) is mounted (die-bonded) on a substrate (for example, a Cu substrate, a Direct Bonded Copper (DBC) substrate having Cu layers on both surfaces, a Direct Bonded Aluminum (DBA) substrate having Al layers on both surfaces, and the like). Therefore, the solder joint in the power device is also required to be hardly remelted under the operating temperature.

As a matter of course, the solder joint in the power device is required to be hardly remelted when the power device and an electronic circuit mounting board are solder-bonded.

As such a solder alloy that suppresses remelting of a solder joint under an operating temperature of a power device and suppresses remelting of a solder joint in the power device when the power device is mounted on a substrate, for example, there is a high temperature lead-free solder alloy comprising 10 to 40 mass% of Sb, 0.5 to 10 mass% of Cu, and a balance of Sn (see Patent Document 1), a high temperature lead-free solder alloy having an alloy composition comprising Sb: 35 to 40 mass%, Ag: 8 to 25 mass%, Cu: 5 to 10 mass%; at least one selected from the group consisting of Al: 0.003 to 1.0 mass%, Fe: 0.01 to 0.2 mass%, and Ti: 0.005 to 0.4; and a balance of Sn (see Patent Document 2), and a solder alloy having an alloy composition comprising Sb: 9.0 to 33.0 mass%, Ag: more than 4.0 mass% and less than 11.0 mass%, Cu: more than 2.0 mass% and less than 6.0 mass%, and a balance of Sn (see Patent Document 3).

Citation List

Patent Literature

Patent Literature 1: JP 2004-298931 A
Patent Literature 2: WO 2014/024715 A
Patent Literature 3: WO 2020/122253 A

Summary of Invention

Technical Problem

Suppression of remelting of a solder joint under a relatively high temperature environment such as an operating temperature of the power device described above is one of problems required for a solder alloy form now on.

An object of the present invention is to solve the above problems, and an object thereof is to provide a solder alloy capable of suppressing remelting of a solder joint to be formed even in a high temperature environment.

Solution to Problem

The solder alloy of the present invention comprises: 0.1 mass% or more and 3 mass% or less of Ag; 8 mass% or more and 15 mass% or less of Cu; 30 mass% or more and 40 mass% or less of Sb; and the balance being Sn.

In the solder alloy of the present invention, wherein the contents (mass%) of Ag, Cu, and Sb preferably satisfy

following formula (A).

$$57.00 \leq Ag \times 0.37 + Cu \times 1.56 + Sb \times 1.46 \leq 82.00 \ ...(A)$$

As in the above formula (A), Ag, Cu, and Sb represent the contents (mass%) of Ag, Cu, and Sb, respectively.

The solder alloy of the present invention may further comprise 0.01 mass% or more and 0.5 mass% or less of Ni.

The solder alloy of the present invention may further comprise 0.01 mass% or more and 0.5 mass% or less of Co.

In the solder alloy of the present invention, a void area $\alpha$ and a void area $\beta$ measured under the following conditions (1) to (5) preferably satisfies the following formula (B).

$$100 - (\text{the void area } \beta/\text{the void area } \alpha \times 100) < 5\% \ ...(B)$$

(1) a Si chip is placed on a copper plate coated with a solder paste comprising a powder consisting of a solder alloy; and a flux comprising a resin, an activator and a solvent, and this is reflowed (peak temperature: 360°C) under a nitrogen atmosphere to prepare a solder joint body having the copper plate, the Si chip, and a solder joint joining the copper plate and the Si chip.

(2) The solder joint body is sealed with a sealing material and heated at 100°C for 60 minutes, and further heated at 150°C for 60 minutes to prepare a test piece.

(3) The surface state of the solder joint of the test piece is observed from an upper surface side (the Si chip side) by an X-ray inspection apparatus, an area of voids generated in the solder joint is measured, and this value is defined as a void area $\alpha$.

(4) The test piece is left under the conditions of 130°C and 85% RH for 24 hours, and then the test piece is reflowed 3 times in a row under the following reflow conditions.

Temperature profile: 80 seconds at 150°C to 180°C, 40 seconds to 50 seconds at 220°C or higher, 35 seconds to 45 seconds at 230°C or higher, peak temperature: 262°C, peak time: 5 seconds to 10 seconds
Heating atmosphere: air

(5) The surface state of the solder joint of the test piece after reflow is observed from the upper surface side (the Si chip side) by the X-ray inspection apparatus, the area of the voids generated in the solder joint is measured, and this value is defined as a void area $\beta$.

In the solder alloy of the present invention, a void area $\alpha'$ and a void area $\beta'$ measured under the following conditions (1)' to (5)' preferably satisfies the following formula (B)'.

$$100 - (\text{the void area } \beta'/ \text{the void area } \alpha' \times 100) < 5\% \ ...(B)'$$

(1)' A flux comprising a resin, an activator and a solvent is applied to a surface of a solder preform consisting of a solder alloy, the solder preform is placed on a copper plate, a Si chip is placed on the surface of the solder preform, and this is reflowed (peak temperature: 360°C) under a nitrogen atmosphere to prepare a solder joint body having the copper plate, the Si chip, and a solder joint joining the copper plate and the Si chip.

(2)' The solder joint body is sealed with a sealing material and heated at 100°C for 60 minutes, and further heated at 150°C for 60 minutes to prepare a test piece.

(3)' The surface state of the solder joint of the test piece is observed from an upper surface side (the Si chip side) by an X-ray inspection apparatus, an area of voids generated in the solder joint is measured, and this value is defined as a void area $\alpha'$.

(4)' The test piece is left under the conditions of 130°C and 85% RH for 24 hours, and then the test piece is reflowed 3 times in a row under the following reflow conditions.

Temperature profile: 80 seconds at 150°C to 180°C, 40 seconds to 50 seconds at 220°C or higher, 35 seconds to 45 seconds at 230°C or higher, peak temperature: 262°C, peak time: 5 seconds to 10 seconds
Heating atmosphere: air

(5)' The surface state of the solder joint of the test piece after reflow is observed from the upper surface side (the Si chip side) by the X-ray inspection apparatus, the area of the voids generated in the solder joint is measured, and this value is defined as a void area $\beta'$.

The solder paste of the present invention comprises a powder consisting of the above-described solder alloy; and a flux comprising a resin, an activator and a solvent.

The solder preform of the present invention comprises the above-described solder alloy.

Advantageous Effects of Invention

The solder alloy of the present invention can suppress remelting of a solder joint to be formed even in a relatively high temperature environment.

Brief Description of Drawings

Fig. 1 is a temperature profile illustrating reflow temperature conditions for producing "solder joint body" according to Examples and Comparative Examples.

Fig. 2 relates to Examples and Comparative Examples, and is an example of an image obtained by photographing each solder joint body using an ultrasonic microscope in (2) Joint strength confirmation test, and represents a bonding interface image (image A) photographed from the Si chip side.

Fig. 3 is a schematic perspective view illustrating a "solder joint body" sealed with an epoxy sealing material in Examples and Comparative Examples.

Fig. 4 relates to Examples and Comparative Examples, and is a temperature profile illustrating reflow temperature conditions in preparing "post-moisture absorption heating test piece" used in (3) Post-moisture absorption reflow test.

Description of Embodiments

Hereinafter, one embodiment of a solder alloy of the present invention will be described in detail. Note that it is needless to say that the present invention is not limited to the embodiment.

1. Solder Alloy

A solder alloy of the present embodiment comprises 0.1 mass% or more and 3 mass% or less of Ag, 8 mass% or more and 15 mass% or less of Cu, and 30 mass% or more and 40 mass% or less of Sb, and the balance being Sn.

The content of Ag comprised in the solder alloy of the present embodiment is preferably 0.1 mass% or more and 3 mass% or less.

Ag can reduce the residual stress of the solder joint by precipitating an $Ag_3Sn$ intermetallic compound in the solder joint to be formed. Thus, the mechanical strength can be maintained.

In addition, since the ratio of the Sn phase (low melting point phase) in the solder joint decreases due to precipitation of the $Ag_3Sn$ intermetallic compound in the solder joint, remelting of the solder joint to be formed can be suppressed even under a high temperature environment.

In the solder alloy of the present embodiment, by setting the content of Ag within this range, the mechanical strength of the solder alloy can be improved, and remelting of the solder joint to be formed can be suppressed even in a high temperature environment. Furthermore, such a solder alloy can improve the bonding strength between the solder joint and a bonding target material.

The content of Ag is more preferably 1 mass% or more and 3 mass% or less, and still more preferably 2 mass% or more and 3 mass% or less.

By setting the content of Ag within this range, the mechanical strength of the solder alloy can be further improved, remelting of the solder joint under a high temperature environment can be further suppressed, and the bonding strength between the solder joint and the bonding target material can be further improved.

The content of Cu comprised in the solder alloy of the present embodiment is preferably 8 mass% or more and 15 mass% or less.

Cu can improve the strength of the solder joint by precipitating a $Cu_6Sn_5$ intermetallic compound or the like in the solder joint to be formed.

In addition, since the ratio of the Sn phase (low melting point phase) in the solder joint decreases due to precipitation of the $Cu_6Sn_5$ intermetallic compound or the like in the solder joint, remelting of the solder joint to be formed can be suppressed even in a high temperature environment.

In the solder alloy of the present embodiment, by setting the content of Cu within this range, the strength of the solder alloy can be improved, and remelting of the formed solder joint can be suppressed even in a high temperature environment.

Meanwhile, such a solder alloy can be sufficiently melted at the time of heating when solder bonding is performed. Therefore, remelting of the solder joint under a high temperature environment can be suppressed without impairing the bonding strength between the solder joint and the bonding target material.

The content of Cu is more preferably 8 mass% or more and 12 mass% or less, and still more preferably 8 mass% or more and 10 mass% or less.

By setting the content of Cu within this range, the strength of the solder alloy can be further improved, and remelting of the solder joint under a high temperature environment can be further suppressed without impairing the bonding strength between the solder joint and the bonding target material.

The content of Sb comprised in the solder alloy of the present embodiment is preferably 30 mass% or more and 40 mass% or less.

Sb can improve the strength of the solder joint by precipitating the SbSn intermetallic compound or the like in the solder joint to be formed.

In addition, since the ratio of the Sn phase (low melting point phase) in the solder joint decreases due to precipitation of the SbSn intermetallic compound or the like in the solder joint, remelting of the solder joint to be formed can be suppressed even in a high temperature environment.

In the solder alloy of the present embodiment, by setting the Sb content within this range, the strength of the solder alloy can be improved, and remelting of the formed solder joint can be suppressed even in a high temperature environment.

The Sb content is more preferably 32 mass% or more and 38 mass% or less, and still more preferably 33 mass% or more and 35 mass% or less.

By setting the Sb content within this range, the strength of the solder alloy can be further improved, and remelting of the solder joint to be formed can be further suppressed even in a high temperature environment.

In addition, the contents (mass%) of Ag, Cu, and Sb comprised in the solder alloy of the present embodiment preferably satisfy following formula (A).

$$57.00 \leq Ag \times 0.37 + Cu \times 1.56 + Sb \times 1.46 \leq 82.00 \ ...(A)$$

As in the above formula (A), Ag, Cu, and Sb represent the contents (mass%) of Ag, Cu, and Sb, respectively.

The above formula (A) calculates the content of Sn used for precipitation of $Ag_3Sn$, $Cu_6Sn_5$, and $Sb_2Sn_3$ among the intermetallic compounds (Sn comprised in these intermetallic compounds) comprised (precipitated) in the solder joint.

That is, the mass ratio of each alloy element other than Sn to Sn is calculated as follows, from the number of atoms of each alloy element comprised in the unit lattice of each intermetallic compound and the atomic weight thereof. Number of atoms of alloy element other than Sn × its atomic weight: Number of atoms of Sn × atomic weight of Sn

Then, from this mass ratio, the content of Sn (mass%) used when each intermetallic compound is precipitated is assumed.

First, regarding $Ag_3Sn$, the mass ratio of Ag and Sn is as follows.

$$(Ag: 3 \times 107.8682):(Sn: 1 \times 118.71) = 323.6046:118.71$$

Therefore, it can be assumed that the amount (mass%) of Sn used per 1 mass% of Ag when $Ag_3Sn$ is precipitated is 118.71/323.6046 = 0.37 (rounded to second decimal places), that is, Ag × 0.37.

Next, regarding $Cu_6Sn_5$, the mass ratio of Cu and Sn is as follows.

$$(Cu: 6 \times 63.546):(Sn: 5 \times 118.71) = 381.276:593.55$$

Therefore, it can be assumed that the amount (mass%) of Sn used per 1 mass% of Cu when $Cu_6Sn_5$ is precipitated is 593.55/381.276 = 1.56 (rounded to second decimal places), that is, Cu × 1.56.

Then, regarding $Sb_2Sn_3$, the mass ratio of Sb and Sn is as follows.

$$(Sb: 2 \times 121.76):(Sn: 3 \times 118.71) = 243.52:356.13$$

Therefore, it can be assumed that the amount (mass%) of Sn used per 1 mass% of Sb when $Sb_2Sn_3$ is precipitated is 356.13/243.52 = 1.46 (rounded to second decimal places), that is, Sb × 1.46.

Then, in a case where the amount of Sn used for precipitation of these intermetallic compounds is within the range of the above formula (A), the ratio of the Sn phase (low melting point phase) comprised in the solder joint can be reduced, so that remelting of the solder joint to be formed can be further suppressed even in a high temperature environment.

In addition, the contents (mass%) of Ag, Cu, and Sb comprised in the solder alloy of the present embodiment more preferably satisfy following formula (A)', and still more preferably satisfy following formula (A)".

$$58.00 \leq Ag \times 0.37 + Cu \times 1.56 + Sb \times 1.46 \leq$$

$$68.00 \ ...(A)'$$

$$60.00 \leq Ag \times 0.37 + Cu \times 1.56 + Sb \times 1.46 \leq$$

$$65.00 \ ...(A)"$$

As in the above formulas (A)' and (A)", Ag, Cu, and Sb represent the contents (mass%) of Ag, Cu, and Sb, respectively.

The solder alloy of the present embodiment can further comprise Ni.

Ni can improve the strength of the solder joint by precipitating the $(Cu, Ni)_6Sn_5$ intermetallic compound having a fine structure in the solder joint to be formed.

The content of Ni comprised in the solder alloy of the present embodiment is preferably 0.01 mass% or more and 0.5 mass% or less. By setting the content of Ni within this range, the strength of the solder alloy can be further improved, and the bonding strength between the solder joint and the bonding target material can be improved.

The content of Ni is more preferably 0.05 mass% or more and 0.5 mass% or less, and still more preferably 0.1 mass% or more and 0.5 mass% or less.

By setting the content of Ni within this range, the strength of the solder alloy can be further improved, and the bonding strength between the solder joint and the bonding target material can be further improved.

The solder alloy of the present embodiment can further comprise Co.

Co can improve the strength of the solder joint by precipitating the $(Cu, Co)_6Sn_5$ intermetallic compound having a fine structure in the solder joint to be formed.

The content of Co comprised in the solder alloy of the present embodiment is preferably 0.01 mass% or more and 0.5 mass% or less. By setting the content of Co within this range, the strength of the solder alloy can be further improved, and the bonding strength between the solder joint and the bonding target material can be improved.

The content of Co is more preferably 0.01 mass% or more and 0.3 mass% or less, and still more preferably 0.01 mass% or more and 0.1 mass% or less.

By setting the content of Co within this range, the strength of the solder alloy can be further improved, and the bonding strength between the solder joint and the bonding target material can be further improved.

The solder alloy of the present embodiment naturally comprises inevitable impurities.

In the solder alloy of the present embodiment, the balance is preferably constituted by Sn.

With such a composition, the solder alloy of the present embodiment can suppress remelting of the formed solder joint even in a high temperature environment, for example, a temperature environment of 250°C or higher such as an operation environment of a power device.

That is, the operating temperature of the power device may reach a high temperature of, for example, 250°C or more. Then, if all or most of the solder joint for solder-bonding the power device and the substrate is remelted under this operating temperature, that is, if the ratio of the liquid phase in the solder joint increases under the above operating temperature, the bonding strength between the power device and the substrate may decrease, and the reliability of the electronic product in which the power device and the substrate are incorporated may also decrease.

In addition, a power semiconductor element mounted on a substrate is provided in the power device, and the substrate and the power semiconductor element are joined via a solder joint. Then, when all or most of the solder joint is remelted under the operating temperature of the power device described above, not only the reliability of the power device itself is reduced, but also the reliability of an electronic product in which such a power device is incorporated can be reduced.

In addition, in solder bonding between the power device and an electronic circuit mounting board, heat of 250°C or higher, for example, is applied to the power device by heating during solder bonding. Therefore, when all or most of the solder joint in the power device is remelted by this heating, not only the reliability of the power device is reduced, but also the reliability of the electronic product in which the power device is incorporated can be reduced.

Therefore, in particular, in a solder alloy used for solder bonding of a power device or for solder bonding between a substrate in the power device and a power semiconductor element, it is required to be able to suppress remelting of a solder joint under such a high-temperature environment.

As described above, since the solder alloy of the present embodiment can suppress remelting of a solder joint to be formed (that is, the ratio of the liquid phase in the solder joint is small) even in a high temperature environment of, for example, 250°C or higher, the solder alloy can be suitably used for solder bonding of a power device and solder bonding between a substrate in the power device and a semiconductor element.

In addition, the solder alloy of the present embodiment can improve the strength of the solder joint. As a result, the solder joint can absorb the stress generated by the difference in the linear expansion coefficient of each bonding target material (for example, a semiconductor element and a substrate), so that the crack generated in each bonding target material can be suppressed.

In addition, the solder alloy of the present embodiment can suppress remelting of a solder joint to be formed under a high-temperature environment without impairing melting of the solder alloy at the time of solder bonding, and thus can improve bonding strength between the solder joint and a bonding target material.

Note that the solder alloy of the present embodiment can also be used for solder bonding between a semiconductor device other than a power device and a substrate, for solder bonding between an electronic component other than a semiconductor device and a substrate, and for mounting of a semiconductor element other than a power semiconductor element on a substrate.

In addition, in the package component such as the power device, the internal component including the solder-bonded substrate and the semiconductor element is sealed with a sealing resin, for example. Depending on the type of the sealing resin, some sealing resins are likely to absorb moisture in the environ air of the package component, and may accumulate moisture therein. Even in a case where a sealing resin having low hygroscopicity is used, moisture in the environ air may be absorbed depending on the storage environment of the package component.

When the package component in a state in which the sealing resin has absorbed moisture is mounted on the substrate, the moisture in the sealing resin is vaporized by heating during solder bonding (heating during reflow), and the volume of the sealing resin may be expanded. In addition, there is a possibility that the package component is damaged due to the volume expansion.

In order to prevent such a phenomenon, Joint Electron Device Engineering Council (US Joint Electronic Device Engineering Council) has established a standard named Moisture Sensitivity Level (MSL).

In the MSL, a moisture absorption life of a moisture-proof packaged package component in a case where the package component is left in the air at 30°C or lower and 60% RH after opening the packaging is defined as a floor life (indoor storage life). Then, levels from 1 to 6 are set on the basis of the floor life, and the risk of above damage is indicated.

A corresponding MSL level is authenticated for each packaged component on the basis of a predetermined test result. In the MSL, in a case where the floor life determined according to the MSL level has elapsed from the time of opening the packaging of the packaged component, the packaged component is required to be subjected to baking treatment or the like.

For example, since the floor life of the MSL level 2 is one year, it is necessary to perform a baking treatment or the like on a packaged component (MSL level 2) for which one year has elapsed since opening of the packaging.

In addition, for example, in order to receive the MSL level 1 certification, it is required that the above-mentioned damage does not occur in the package component even in a case where the package component is dried at 125°C for 24 hours, then moistened at 85°C and 85% RH for 168 hours, and then heated twice by reflow at a peak of 260°C.

As described above, while severe storage conditions are required for moisture absorption of the sealing resin of the package component, moisture contained in the sealing resin may not be completely discharged even by baking.

In addition, although the above-mentioned damage is not achieved, the sealing resin whose volume is expanded by vaporization of internal moisture due to heating during solder bonding may generate a force to peel off from the internal component including the solder-bonded substrate and the semiconductor element, that is, a force toward the outside of the package component. Then, this force generates a gap between the sealing resin and the substrate or the lead frame inside the package component.

Furthermore, at this time, if all or most of the solder joint that joins the substrate inside the package component and the semiconductor element is remelted by heating during solder bonding, remelted solder derived from the solder joint may flow into the above-mentioned gap to cause a short circuit.

In addition, when the remelted solder derived from the solder joint flows out into the above-mentioned gap, voids are likely to be generated in the solder joint. Therefore, such a phenomenon also lowers the reliability of the solder joint itself.

On the other hand, as described above, the solder alloy of the present embodiment can suppress remelting of a solder joint to be formed even in a high temperature environment such as 250°C or higher, for example.

Therefore, the solder alloy of the present embodiment can suppress the outflow of the remelted solder derived from the solder joint into the above-mentioned gap even in a case where, for example, a package component including a sealing resin that has absorbed moisture is solder-bonded, so that solder bonding can be performed without impairing the reliability of the package component.

In addition, the solder alloy of the present embodiment preferably has a variation rate (100 - (the value after moisture absorption heating/the initial value × 100)) of less than 5% between the initial value of the void area and the value after moisture absorption heating in a case where a test is conducted under the following conditions and procedures of (1) to (5).

That is, in the solder alloy of the present embodiment, it is preferable that a void area $\alpha$ and a void area $\beta$ measured under the following conditions (1) to (5) satisfy following formula (B).

$$100 - (\text{the void area } \beta/\text{the void area } \alpha \times 100) < 5\% \ \text{...(B)}$$

(1) A Si chip is placed on a copper plate coated with a solder paste comprising a powder consisting of a solder alloy; and a flux comprising a resin, an activator and a solvent, and this is reflowed (peak temperature: 360°C) under a nitrogen atmosphere to prepare a solder joint body having the copper plate, the Si chip, and a solder joint joining the copper plate and the Si chip.

(2) The solder joint body is sealed with a sealing material, heated at 100°C for 60 minutes, and further heated at 150°C for 60 minutes to prepare a test piece.

(3) The surface state of the solder joint of the test piece is observed from an upper surface side (the Si chip side) by an X-ray inspection apparatus, and an area of voids generated in the solder joint is measured. Then, this value (an initial value) is defined as a void area $\alpha$.

(4) The test piece is left under the condition of 130°C and 85% RH for 24 hours, and then the test piece is reflowed 3 times in a row under the following reflow conditions.

Temperature profile: 80 seconds at 150°C to 180°C, 40 seconds to 50 seconds at 220°C or higher, 35 seconds to 45 seconds at 230°C or higher, peak temperature: 262°C, peak time: 5 seconds to 10 seconds
Heating atmosphere: air

(5) The surface state of the solder joint of the test piece after reflow is observed from the upper surface side (the Si chip side) by the X-ray inspection apparatus, the area of the voids generated in the solder joint is measured, and this value (a value after moisture absorption heating) is defined as a void area $\beta$.

Detailed conditions of the above-described measurement are as follows.

<Tool>

Size of a copper plate: 20 mm × 20 mm × 0.5 mmt
A size of Si chip: 5 mm × 5 mm × 0.3 mmt (Ti film formation and Ni film formation are sequentially performed from the Si chip side on the back electrode of the Si chip. Thickness of Ti film formation: 0.1 um, thickness of Ni film formation: 0.5 $\mu$m)
Solder paste: comprises a powder consisting of the solder alloy of the present embodiment and a flux comprising a resin, an activator and a solvent. Note that a solder paste described later can be used.

Sealing material: epoxy resin (Product name: T693/R1001, manufactured by Nagase ChemteX Corporation)

About (1)

Application range (size) of solder paste to be applied onto copper plate: 3.5 mm × 3.5 mm × 0.2 mmt
Conditions for reflowing the copper plate on which the Si chip is placed are as follows.

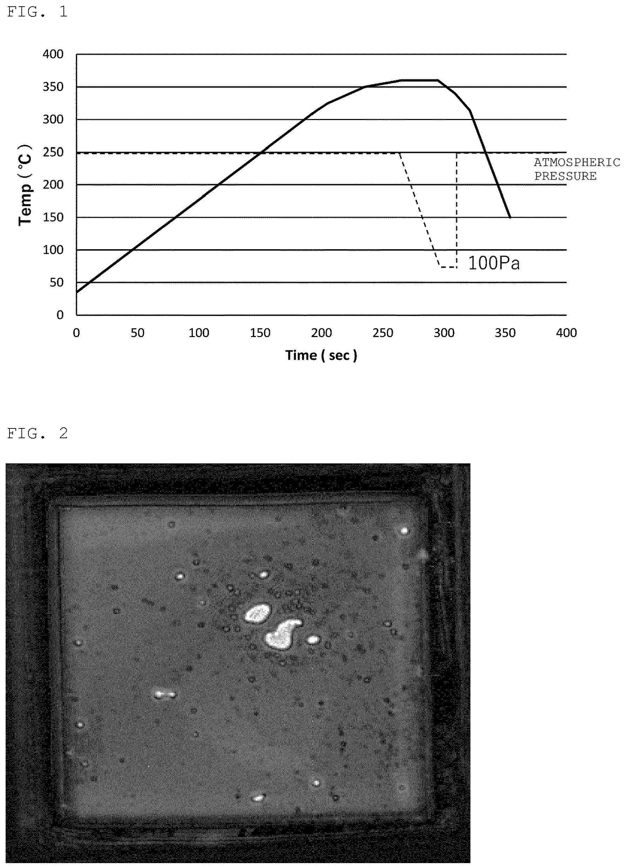

The mount load condition is set to 30 g, and reflow is performed using a reflow device (Product name: SMT Scope SK-5000, manufactured by Sanyo Seiko Corporation) on the basis of the temperature profile condition (peak temperature: 360°C) illustrated in Fig. 1.

Note that, during the reflow, heating is started under a $N_2$ atmosphere with an oxygen concentration of 500 ppm and under atmospheric pressure, and when the reflow temperature reaches 360°C, vacuuming is performed to reduce the pressure in the reflow device to 100 Pa. In addition, the time from the moment when the peak temperature reaches 360°C until the moment when the pressure in the reflow device reaches 100 Pa is set to 30 seconds.

Then, the heating is stopped, and when the temperature in the reflow device reaches 340°C, the pressure reduction is released to return the pressure in the reflow device to atmospheric pressure, and cooling is performed in the air atmosphere. The change in pressure in the reflow device with the temperature profile (illustrated in dotted lines) is also illustrated in Fig. 1.

About (2)

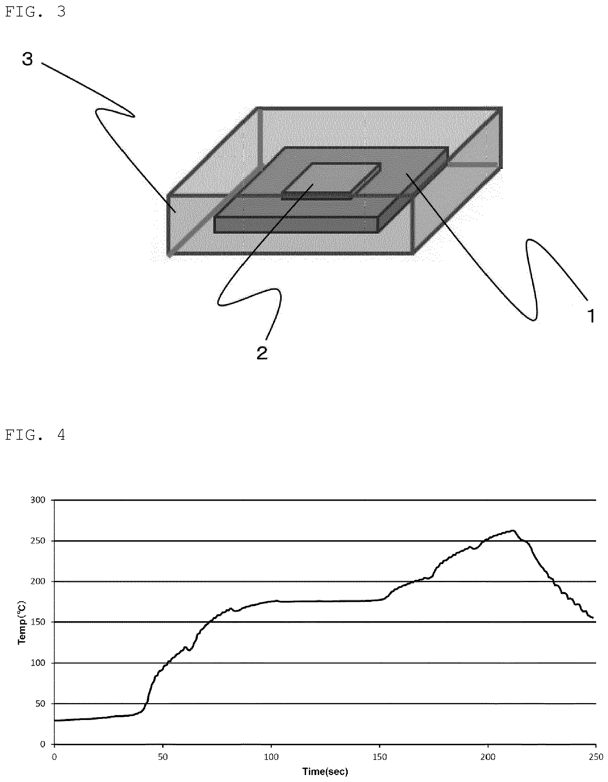

The solder joint body is immersed in a sealing material and vacuumed to seal the solder joint body using the sealing material. In this way, the solder joint body is brought into close contact with the sealing material. This sealed state is illustrated in Fig. 3.

Then, the sealed solder joint body is heated using a forced convection oven (Product name: DKN 402, manufactured by Yamato Scientific Co., Ltd.).

About (4)

The test piece is left for 24 hours under the condition of 130°C and 85% RH using a highly accelerated stress test chamber (Product name: PC-422 R8D, manufactured by HIRAYAMA Manufacturing Corporation). Thereafter, reflow is performed using a reflow furnace (Product name: TNV30-508EM2-X, manufactured by TAMURA Corporation).

In addition, the solder alloy of the present embodiment preferably has a variation rate (100 - (the value after moisture absorption heating/the initial value × 100)) of less than 5% between the initial value of the void area and the value after moisture absorption heating in a case where a test is conducted under the following conditions and procedures of (1)' to (5)'.

That is, in the solder alloy of the present embodiment, it is preferable that a void area $\alpha'$ and a void area $\beta'$ measured under the following conditions (1)' to (5)' satisfy following formula (B)'.

$$100 - (\text{a void area } \beta' / \text{a void area } \alpha' \times 100) < 5\% \quad ...(B)'$$

(1)' A flux comprising a resin, an activator and a solvent is applied to a surface of a solder preform consisting of a solder alloy, and this is placed on a copper plate, then, a Si chip is placed on the surface of the solder preform, and this is reflowed (peak temperature: 360°C) under a nitrogen atmosphere to prepare a solder joint body having the copper plate, the Si chip, and a solder joint joining the copper plate and the Si chip.

(2)' The solder joint body is sealed using a sealing material, heated at 100°C for 60 minutes, and further heated at 150°C for 60 minutes to prepare a test piece.

(3)' The surface state of the solder joint of the test piece is observed from the upper surface side (the Si chip side) with an X-ray inspection apparatus, an area of voids generated in the solder joint is measured, and this value (an initial value) is defined as a void area $\alpha'$.

(4)' The test piece is left under the condition of 130°C and 85% RH for 24 hours, and then the test piece is reflowed 3 times in a row under the following reflow conditions.

Temperature profile: 80 seconds at 150°C to 180°C, 40 seconds to 50 seconds at 220°C or higher, 35 seconds to 45 seconds at 230°C or higher, peak temperature: 262°C, peak time: 5 seconds to 10 seconds

Heating atmosphere: air

(5)' The surface state of the solder joint of the test piece after reflow is observed from the upper surface side (the Si chip side) by the X-ray inspection apparatus, the area of the voids generated in the solder joint is measured, and this value (a value after moisture absorption heating) is defined as a void area β'.

Detailed conditions of the above-described measurement are as follows.

<Tool>

Except for the solder preform, the same tool as the tool used for measuring the above-described void area α and the void area β is used.

Solder preform size: 3.5 mm × 3.5 mm × 0.1 mmt
Note that a solder preform described later can be used.

About (1)'

The solder preform is immersed in the flux, and then the flux (applied to the surface of the solder preform) is dried to volatilize the solvent component, thereby applying the flux to the surface of the solder preform.
Note that the conditions for reflowing the copper plate on which the Si chip is placed are the same as the conditions in the above (1).

About (2) ' to (4)'

The conditions are the same as those in the above (1) to (4).
In the solder alloy satisfying the above formulas (B) and (B)', even in a case where a gap is generated between the sealing resin and the substrate or the lead frame inside the package component at the time of solder bonding, it is possible to further suppress the remelted solder derived from the solder joint from flowing out to the gap. In addition, this makes it possible to suppress the generation of voids in the solder joints due to this outflow, so that it is possible to provide a solder joint and a package component with higher reliability.

2. Solder Paste

The solder paste of the present embodiment comprises, for example, a powder consisting of the solder alloy of the present embodiment and a flux.
The flux comprises, for example, a resin, an activator and a solvent.
The solder paste of the present embodiment is prepared, for example, by kneading a powder consisting of the above-described solder alloy and a flux by a known method. The mixing ratio of the two is not particularly limited. For example, the mixing ratio can be set to powder consisting of a solder alloy: flux = 65:35 to 95:5.
Examples of the resin comprise, for example, rosin resin; acrylic resin obtained by polymerizing at least one monomer of acrylic acid, methacrylic acid, various esters of acrylic acid, various esters of methacrylic acid, crotonic acid, itaconic acid, maleic acid, maleic anhydride, esters of maleic acid, esters of maleic anhydride, acrylonitrile, methacrylonitrile, acrylamide, methacrylamide, vinyl chloride, vinyl acetate, and the like; epoxy resin; phenol resins and the like. These can be used alone or in combination of two or more.
Examples of the rosin resin comprise, for example, rosins such as tall oil rosin, gum rosin, and wood rosin; rosin-modified resins such as hydrogenated rosin (partial hydrogenation and complete hydrogenation), polymerized rosin, heterogenized rosin, acrylic acid-modified rosin, maleic acid-modified rosin, and formylated rosin; and derivatives thereof. These can be used alone or in combination of two or more.
Examples of the activator comprise, for example, organic acids, halogen-containing compounds, and aminebased activators. These can be used alone or in combination of two or more.
Examples of the solvent comprise alcohol- type, ethanol type, acetone type, toluene type, xylene type, ethyl acetate type, ethyl cellosolve type, butyl cellosolve type, glycol ether type, and ester type activators. These can be used alone or in combination of two or more.
A thixotropic agent can be blended in the flux. Examples of the thixotropic agent comprise hardened castor oil, a bisamide-based thixotropic agent (saturated fatty acid bisamide, unsaturated fatty acid bisamide, aromatic bisamide, and the like), and dimethyldibenzylidene sorbitol. These can be used alone or in combination of two or more.

An antioxidant can be blended in the flux.

Examples of the antioxidant comprise hindered phenol-type antioxidants, phenol-type antioxidants, bisphenol-type antioxidants, and polymer-type antioxidants. Among them, a hindered phenol-based antioxidant is particularly preferably used.

Additives such as a matting agent and an antifoaming agent may be further added to the flux of the present embodiment.

3. Solder Preform

The solder preform of the present embodiment comprises the solder alloy of the present embodiment.

As the solder preform of the present embodiment, for example, disk-shaped, square-shaped, tape-shaped, or the like can be used. In preparing these solder preforms, known methods can be used.

In addition, the shape and thickness of the solder preform can be appropriately adjusted depending on the substrate to be used, the solder bonding method, the type of electronic component or semiconductor element to be solder-bonded, and the like.

In addition, solder bonding using the solder preform of the present embodiment can be performed by applying the above-described flux to the surface of the solder preform, or can be performed by previously flux-coating an organic acid or the like on the surface of the solder preform.

The solder preform of the present embodiment can also be solder-bonded by using, for example, formic acid reflow, hydrogen reflow, or the like in a reducing atmosphere.

The solder alloy of the present embodiment can be used not only for the solder paste and the solder preform described above but also for other applications such as solder balls and wires.

Examples

Hereinafter, the present invention will be described in detail with reference to Examples and Comparative Examples. Note that the present invention is not limited to these Examples.

<Preparation of Flux>

The following components were prepared to obtain a flux.

Resin: KE-604 (acrylic modified hydrogenated rosin, manufactured by Arakawa Chemical Industries, Ltd.) 50 mass%
Activator: 2 mass% of suberic acid, 0.5 mass% of malonic acid, and 1 mass% of dibromobutenediol
Solvent: diethylene glycol monohexyl ether (DEH) 38.5 mass%
Thixotropic agent: 5 mass% of Himakou (12 hydroxystearic acid triglyceride, manufactured by KF Trading Co., Ltd.)
Additive: IRGANOX 245 (hindered phenol-based antioxidant manufactured by BASF Japan Ltd.) 3 mass%

11.0 mass% of the flux and 89.0 mass% of a powder of each solder alloy described in Table 1 (powder particle size: 20 um to 38 μm) were mixed to prepare solder pastes according to Examples and Comparative Examples.

Note that the "value of formula (a)" illustrated in Table 1 is a value calculated using the following formula (a) on the basis of the contents (mass%) of Ag, Cu, and Sb of each solder alloy.

$$Ag \times 0.37 + Cu \times 1.56 + Sb \times 1.46 \ ...(a)$$

As in the above formula (a), Ag, Cu, and Sb represent the contents (mass%) of Ag, Cu, and Sb, respectively.

[Table 1]

|  | Sn | Ag | Cu | Sb | Ni | Co | Value of formula (a) |
|---|---|---|---|---|---|---|---|
| Example 1 | Balance | 2 | 10 | 35 | - | - | 67.44 |
| Example 2 | Balance | 0.3 | 8 | 38 | 0.05 | - | 68.07 |
| Example 3 | Balance | 2 | 10 | 38 | - | 0.01 | 71.82 |

(continued)

|  | Sn | Ag | Cu | Sb | Ni | Co | Value of formula (a) |
|---|---|---|---|---|---|---|---|
| Example 4 | Balance | 2 | 10 | 35 | 0.05 | 0.01 | 67.44 |
| Example 5 | Balance | 0.3 | 8 | 38 | 0.05 | 0.01 | 68.07 |
| Example 6 | Balance | 0.1 | 8 | 34 | 0.5 | 0.01 | 62.16 |
| Example 7 | Balance | 2 | 8 | 34 | 0.5 | 0.01 | 62.86 |
| Example 8 | Balance | 3 | 8 | 34 | 0.5 | 0.01 | 63.23 |
| Example 9 | Balance | 1.5 | 15 | 35 | 0.05 | 0.3 | 75.06 |
| Example 10 | Balance | 1.5 | 8 | 40 | 0.05 | 0.05 | 71.44 |
| Example 11 | Balance | 1.5 | 8 | 35 | 0.5 | 0.01 | 64.14 |
| Example 12 | Balance | 1 | 8 | 31 | 0.01 | 0.5 | 58.11 |
| Example 13 | Balance | 3 | 15 | 40 | 0.5 | 0.5 | 82.91 |
| Example 14 | Balance | 0.1 | 8 | 30 | 0.05 | 0.05 | 56.32 |
| Comparative Example 1 | Balance | 3 | 0.5 | - | - | - | 1.89 |
| Comparative Example 2 | Balance | - | - | 10 | - | - | 14.60 |
| Comparative Example 3 | Balance | - | 8 | 15 | 0.05 | 0.05 | 34.38 |
| Comparative Example 4 | Balance | 1 | 5 | 20 | 0.05 | 0.05 | 37.37 |
| Comparative Example 5 | Balance | - | 8 | 35 | 0.05 | 0.05 | 63.58 |
| Comparative Example 6 | Balance | 3.5 | 8 | 35 | 0.05 | 0.05 | 64.88 |
| Comparative Example 7 | Balance | 0.1 | 7 | 29 | 0.05 | 0.05 | 53.30 |
| Comparative Example 8 | Balance | 3 | 16 | 41 | 0.05 | 0.05 | 85.93 |
| Comparative Example 9 | Balance | 0.01 | 7.8 | 29 | 0.001 | 0.001 | 54.51 |
| Comparative Example 10 | Balance | 3.5 | 16 | 41 | 0.55 | 0.55 | 86.12 |

(1) Si chip fracture confirmation test

The following tools were prepared for each of Examples and Comparative Examples.

- A copper plate (size: 20 mm × 20 mm × 0.5 mmt)
- A Si chip (size: 5 mm × 5 mm × 0.3 mmt, Ti film formation and Ni film formation are sequentially performed from the Si chip side on the back electrode of Si chip. Ti thickness: 0.1 um, Ni thickness: 0.5 $\mu$m)
- A metal mask (opening: 3.5 mm × 3.5 mm, thickness: 0.2 mm)

Each solder paste was printed on the copper plate (center) using the metal mask.
Next, the Si chip was placed on the surface (center) of each solder paste printed thereon, and this was reflowed under the following conditions to prepare each solder joint body having the copper plate, the Si chip, and a solder joint for joining them.

• Reflow condition

Under the mount load condition of 30 g, reflow was performed using a reflow device (Product name: SMT Scope SK-5000, manufactured by Sanyo Seiko Corporation) on the basis of the temperature profile condition (peak temperature: 360°C) illustrated in Fig. 1.
Note that, in the reflow, heating was started under a $N_2$ atmosphere with an oxygen concentration of 500 ppm and under atmospheric pressure, and vacuuming was performed when the reflow temperature reached the peak temperature of 360°C to reduce the pressure in the reflow device to 100 Pa. Note that the time from the moment when the peak temperature reached 360°C until the moment when the pressure in the reflow device reached 100 Pa was set to 30 seconds.

Then, the heating was stopped, the pressure reduction was released when the temperature in the reflow device reached 340°C, the pressure in the reflow device was returned to atmospheric pressure, and the subsequent cooling was performed under the air atmosphere. The change in pressure in the reflow device with the temperature profile (illustrated in dotted lines) is also illustrated in Fig. 1.

Then, for each solder joint body, whether or not a crack was generated in the Si chip was confirmed using a microscope (Product name: Digital Microscope VHX-900, manufactured by KEYENCE CORPORATION), and evaluation was performed according to the following criteria. The results are illustrated in Table 2.

○: No crack is generated in the Si chip.
△: Crack of less than 1 mm is generated in the Si chip.
×: Crack of 1 mm or more is generated in the Si chip.

(2) Joint strength confirmation test

For each solder joint body used in the above-described (1) Si chip fracture confirmation test, a bonding interface image A (image A) photographed from the Si chip side was acquired using an ultrasonic microscope (Product name: C-SAM Gen6, manufactured by Nordson Advanced Technology Inc.).

Then, the area (area X) of a region where the Si chip and the solder joint were joined within the region (region A) where the Si chip and the solder joint were seen to overlap on the image A was calculated by the following method.

That is, the area of the region A (area Y) and the area of the non-bonded portion (portion illustrated in white in region A, as illustrated in Fig. 2) in the region A (area Z) were calculated, and the value obtained by subtracting the area Z from the area Y was taken as the area X.

Then, a value (area X/area Y × 100) obtained by dividing the calculated area X by the area Y was defined as a bonding ratio (%), and evaluation was performed according to the following criteria. The results are illustrated in Table 2.

○: The bonding ratio is 80% or more.
△: The bonding ratio is 50% or more and less than 80%
×: The bonding ratio is less than 50%.

(3) Post-moisture absorption reflow test

Using an epoxy sealing material (Product name: T693/R1001, manufactured by Nagase ChemteX Corporation), each of the solder joint bodies subjected to the above-described (2) Joint strength confirmation test was sealed by the following method.

That is, each of the solder joint bodies was immersed in the epoxy sealing material, and then vacuuming was performed. Thereby, the solder joint body and the epoxy sealing material were brought into close contact with each other. This sealed state is illustrated in Fig. 3.

Note that the size of the epoxy sealing material 3 illustrated in Fig. 3 is 26 mm × 26 mm × 3 mmt.

Then, each of the solder joint bodies sealed with the epoxy sealing material was heated at 100°C for 60 minutes and then further heated at 150°C for 60 minutes using a forced convection oven (Product name: DKN 402, manufactured by Yamato Scientific Co., Ltd.) to prepare each test piece.

Then, the surface state of each of the test pieces was observed from the upper surface side (the Si chip side) with an X-ray inspection apparatus, the area of the voids generated in the solder joint of each of the test pieces was measured, and this value was defined as a void area $\alpha$ (an initial value).

Next, each of the test pieces was left for 24 hours under the conditions of 130°C and 85% RH using a highly accelerated stress test chamber (Product name: PC-422 R8D, manufactured by HIRAYAMA Manufacturing Corporation), and then reflow was performed three times in a row under the air atmosphere on the basis of the temperature profile conditions (peak temperature: 262°C) illustrated in Fig. 4 using a reflow furnace (Product name: TNV30-508EM2-X, manufactured by TAMURA Corporation) to prepare each of the post-moisture absorption heating test pieces.

The surface state of the solder joint of each of the post-moisture absorption heating test pieces was observed from the upper surface side (the Si chip side) with an X-ray inspection apparatus, the area of the voids generated in the solder joint of each of the post-moisture absorption heating test pieces was measured, and this value was defined as a void area $\beta$ (a value after moisture absorption heating).

Then, for the "void area $\alpha$ (the initial value)" and the "void area $\beta$ (the value after moisture absorption heating)" measured for each Example and each Comparative Example, the variation rate (%) of the void area was calculated on the basis of the following formula.

$$\text{Void area variation rate (\%)} = 100 - (\text{void area } \beta/\text{void area } \alpha \times 100)$$

The calculated void area variation rate (%) in each of Examples and Comparative Examples was evaluated according to the following criteria. The results are illustrated in Table 2.

○: The variation rate of the void area is 0%.

△: The variation rate of the void area is less than 5%.

×: The variation rate of the void area is 5% or more.

[Table 2]

|  |  | (1) Si chip fracture confirmation test | (2) Joint strength confirmation test | (3) Post-moisture absorption reflow test |
|---|---|---|---|---|
|  | Example 1 | ○ | △ | △ |
|  | Example 2 | ○ | △ | ○ |
|  | Example 3 | ○ | △ | ○ |
|  | Example 4 | ○ | △ | ○ |
|  | Example 5 | ○ | △ | ○ |
|  | Example 6 | ○ | △ | ○ |
|  | Example 7 | ○ | ○ | ○ |
|  | Example 8 | ○ | ○ | ○ |
|  | Example 9 | ○ | △ | ○ |
|  | Example 10 | ○ | ○ | △ |
|  | Example 11 | ○ | △ | ○ |
|  | Example 12 | ○ | ○ | △ |
|  | Example 13 | △ | △ | ○ |
|  | Example 14 | ○ | △ | △ |
|  | Comparative Example 1 | ○ | ○ | × |
|  | Comparative Example 2 | ○ | ○ | × |
|  | Comparative Example 3 | ○ | ○ | × |
|  | Comparative Example 4 | ○ | ○ | × |
|  | Comparative Example 5 | ○ | × | ○ |
|  | Comparative Example 6 | × | ○ | ○ |
|  | Comparative Example 7 | ○ | ○ | × |

(continued)

|  | (1) Si chip fracture confirmation test | (2) Joint strength confirmation test | (3) Post-moisture absorption reflow test |
|---|---|---|---|
| Comparative Example 8 | ✕ | ✕ | ○ |
| Comparative Example 9 | ○ | ○ | ✕ |
| Comparative Example 10 | ✕ | ✕ | ○ |

As described above, since the contents of Ag, Cu, Sb, and Sn in the solder alloys of Examples are each within a predetermined range, remelting of a solder joint to be formed can be suppressed even in a high temperature environment.

Therefore, in the solder alloys of Examples, even in a case where the sealing material (sealing resin) that has absorbed moisture expands due to heating and a gap is generated between the copper plate and the Si chip and the sealing material, the outflow of the remelted solder derived from the solder joint into the above-described gap can be suppressed, and the generation of voids in the solder joint caused by the inflow of the remelted solder can be suppressed.

Furthermore, in the solder alloys of Examples, the contents of Ag, Cu, Sb, and Sn is each within a predetermined range, so that the strength of the formed solder joint can be increased, and the solder alloy can be sufficiently melted at the time of heating when solder bonding is performed.

Therefore, the solder alloys of Examples can improve the bonding strength between the solder joint and the bonding target material (copper plate and Si chip), and can provide a highly reliable solder joint.

Note that, in the solder alloys of Examples (Examples 2 to 14), the contents of Ag, Cu, Sb, and Sn are each within a predetermined range, and at least one of Ni and Co is comprised in a predetermined amount, so that all the test results are good particularly in Examples 7 and 8.

As described above, the solder alloy of the present invention can provide a more reliable solder joint.

Note that Comparative Examples 1 to 3 do not comprise any of Ag, Cu, and Sb. Therefore, it is considered that the remelted solder derived from the solder joint flowed into the gap described above under a high temperature environment. Therefore, the results of (3) Post-moisture absorption reflow test were ✕.

In Comparative Example 5, although Ag is not comprised, the result of (3) Post-moisture absorption reflow test is o. This is considered to be because the solder alloy of Comparative Example 5 comprised more Sb than Comparative Example 3, so that the solder joint was difficult to remelt during reflow in a row after moisture absorption.

However, the solder alloy of Comparative Example 5 does not comprised Ag as described above. Therefore, in this solder alloy, the bonding strength between the solder joint and the bonding target material was not sufficient, and thus the result of (2) Joint strength confirmation test of Comparative Example 5 was ✕.

In Comparative Examples 4 and 7, since the contents of Cu and Sb were out of the predetermined range (less than the lower limit), it is considered that the remelted solder derived from the solder joint flowed into the above-described gap under a high temperature environment. Therefore, the results of (3) Post-moisture absorption reflow test were ✕.

In Comparative Example 6, it is considered that since the content of Ag was outside the predetermined range (above the upper limit), coarsening of the Ag-derived intermetallic compound was caused, and conversely, the strength of the solder joint was reduced. Therefore, the result of (1) Si chip fracture confirmation test of Comparative Example 6 was ✕.

In Comparative Example 8, it is considered that since the contents of Cu and Sb were outside the predetermined range (above the upper limit), melting at the time of heating during solder bonding was not sufficient, and therefore the bonding strength between the solder joint and the bonding target material was reduced. Therefore, the result of (2) Joint strength confirmation test of Comparative Example 8 was ✕.

In addition, in Comparative Example 8, it is considered that the intermetallic compounds derived from Cu and Sb were coarsened, and conversely, the strength of the solder joint was reduced. Therefore, the result of (1) Si chip fracture confirmation test of Comparative Example 8 was also ✕.

In Comparative Example 9, since the contents of Ag, Cu, and Sb were out of the predetermined range (less than the lower limit), it is considered that the remelted solder derived from the solder joint flowed into the gap described above under a high temperature environment. Therefore, the result of (3) Post-moisture absorption reflow test of Comparative Example 9 was ✕.

In Comparative Example 10, since the contents of Ag, Cu, and Sb were out of the predetermined range (above the upper limit), melting at the time of heating during solder bonding was not sufficient, and therefore it is considered that the bonding strength between the solder joint and the bonding target material was reduced. Therefore, the result of (2) Joint strength confirmation test of Comparative Example 10 was ×.

In addition, in Comparative Example 10, it is considered that the intermetallic compounds derived from Ag, Cu, and Sb were coarsened, and conversely, the strength of the solder joint was reduced. Therefore, the result of (1) Si chip fracture confirmation test of Comparative Example 10 was ×.

Reference Signs List

1    Copper plate

2    Si chip

3    Epoxy sealing material

**Claims**

1. A solder alloy comprising: 0.1 mass% or more and 3 mass% or less of Ag; 8 mass% or more and 15 mass% or less of Cu; 30 mass% or more and 40 mass% or less of Sb; and the balance being Sn.

2. The solder alloy according to claim 1, wherein the contents (mass%) of Ag, Cu, and Sb satisfying following formula (A),

$$57.00 \leq Ag \times 0.37 + Cu \times 1.56 + Sb \times 1.46 \leq 82.00 \ ...(A)$$

As in the above formula (A), Ag, Cu, and Sb represent the contents (mass%) of Ag, Cu, and Sb, respectively.

3. The solder alloy according to claim 1 or 2, further comprising 0.01 mass% or more and 0.5 mass% or less of Ni.

4. The solder alloy according to any one of claims 1 to 3, further comprising 0.01 mass% or more and 0.5 mass% or less of Co.

5. A solder paste comprising:

   a powder consisting of the solder alloy according to any one of claims 1 to 4; and
   a flux comprising a resin, an activator and a solvent.

6. A solder preform comprising the solder alloy according to any one of claims 1 to 4.

FIG. 1

FIG. 2

FIG. 3

FIG. 4

# EP 4 317 496 A1

<table>
<tr><td colspan="2">INTERNATIONAL SEARCH REPORT</td><td>International application No.<br><br>**PCT/JP2022/014030**</td></tr>
</table>

| A. | CLASSIFICATION OF SUBJECT MATTER |
|---|---|

*C22C 13/02*(2006.01)i; *C22C 30/04*(2006.01)i; *B23K 35/22*(2006.01)i; *B23K 35/26*(2006.01)i; *H05K 3/34*(2006.01)i
FI:   B23K35/26 310A; B23K35/22 310A; C22C13/02; C22C30/04; H05K3/34 512C

According to International Patent Classification (IPC) or to both national classification and IPC

| B. | FIELDS SEARCHED |
|---|---|

Minimum documentation searched (classification system followed by classification symbols)
C22C13/02; C22C30/04; B23K35/22; B23K35/26; H05K3/34

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2018-47489 A (NIHON DEMPA KOGYO CO., LTD.) 29 March 2018 (2018-03-29)<br>      entire text | 1-6 |
| A | KR 10-2020-0082107 A (HYUNDAI MOTOR CO., LTD.) 08 July 2020 (2020-07-08)<br>      entire text | 1-6 |
| A | JP 2004-298931 A (SENJU METAL INDUSTRY CO., LTD.) 28 October 2004 (2004-10-28)<br>      entire text | 1-6 |
| A | JP 2005-122970 A (MATSUSHITA ELECTRIC INDUSTRIAL CO., LTD.) 12 May 2005<br>(2005-05-12)<br>      entire text | 1-6 |
| A | JP 2005-340268 A (RENESAS TECHNOLOGY CORP.) 08 December 2005 (2005-12-08)<br>      entire text | 1-6 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **31 May 2022** | **07 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

| International application No. |
| --- |
| **PCT/JP2022/014030** |

| Patent document cited in search report | | | Publication date (day/month/year) | Patent family member(s) | | | Publication date (day/month/year) |
| --- | --- | --- | --- | --- | --- | --- | --- |
| JP | 2018-47489 | A | 29 March 2018 | US 2018/079036 A1 whole document CN 107866646 A TW 201829796 A | | | |
| KR | 10-2020-0082107 | A | 08 July 2020 | (Family: none) | | | |
| JP | 2004-298931 | A | 28 October 2004 | (Family: none) | | | |
| JP | 2005-122970 | A | 12 May 2005 | US 2006/0061281 A1 whole document WO 2005/038847 A1 KR 10-2006-0130548 A CN 1868022 A | | | |
| JP | 2005-340268 | A | 08 December 2005 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004298931 A
- WO 2014024715 A
- WO 2020122253 A